# EUROPEAN PATENT APPLICATION

(11) **EP 4 750 255 A1**
(43) Date of publication of application: **27.05.2026**
(21) Application number: 25214406.8
(22) Date of filing: 07.11.2025
(51) Int. Cl.: H10D 30/66, H10D 62/10, H10D 64/00, H10D 64/27

(54) **SPLIT-GATE MOSFET WITH IMPROVED RELIABILITY**

(30) Priority: 26.11.2024 IT 202400026538
(71) Applicant: STMicroelectronics International N.V., 1228 Plan-les-Ouates, Geneva (CH)
(72) Inventor: ENEA, Vincenzo, 20864 AGRATE BRIANZA (MB) (IT)
(74) Representative: Studio Torta S.p.A.

(57) **Abstract**

Electronic device (10), comprising: a semiconductor body (12); trenches (13) in the semiconductor body (12) from the first side (12a) towards the second side (12b), terminating in the semiconductor body (12) and arranged at the side of each other along a second axis (X) orthogonal to the first axis (Z); a respective insulating field plate region (14) with a main body (14a) in each of said trenches (13), covering the lower and lateral walls of the respective trench (13); a respective field plate region (16) in each of said trenches (13), each field plate region (16) being buried in the insulating field plate region (14) and being electrically insulated from the semiconductor body (12) by means of the insulating field plate region (14); and a respective first conductive gate region (15a) for each of said trenches (13), each first conductive gate region (15a) extending in the semiconductor body (12) from the first side (12a) towards the second side (12b) and terminating in the semiconductor body (12), extending laterally to the main body (14a) of the respective insulating field plate region (14) along the second axis (X), being of conductive material and being electrically insulated from the semiconductor body (12) and the respective field plate region (16).

## Description

### TECHNICAL FIELD

The present invention relates to a split-gate MOSFET with improved reliability, in particular by virtue of conductive gate regions lateral to the insulating field plate regions. Furthermore, it relates to a manufacturing process of the electronic device.

### BACKGROUND

MOSFET ("Metal-Oxide-Semiconductor Field-Effect Transistor") technology is now widely recognized as an excellent option for several applications, for example for switches in power supply management circuits.

Commercially available now for decades, vertical diffused MOSFET (VDMOS) devices have seen significant commercial spread by virtue of their improved electrical performances. However, for a long time, VDMOSFETs have had a high on-state resistance that limited their current handling capabilities.

This problem has been overcome with "trench-gate" MOSFETs. By virtue of the vertical-direction channel, these devices allow a reduction in cell pitch without negatively affecting current spread. In particular, the introduction of devices that use a field plate, insulated from the gate electrode and connected to the source potential, as an extension of the gate electrode has enabled the lateral depletion of the off-state drift region. Since the field plate is electrically insulated from the gate electrode, this structure is also known as "shielded-gate" or "split-gate" structure.

Split-gate technology offers significant advantages with respect to previous MOSFETs, for example an improved on-resistance with respect to the active area extension and reduced gate-drain capacity. In fact, the split-gate structure allows the use of high doping concentrations, leading to significant improvements in MOSFET performances.

As known, one of the main goals in the development of split-gate power MOSFET devices is to achieve accurate control of the various steps of the diffusion/manufacturing process to reduce as much as possible the "spread" of the final electrical properties.

Usually, these MOSFETs are formed by using a wet etching of the "field plate" oxide region to create the cavity wherein the conductive gate region is then formed. However, this approach, although simple to perform, causes a significant spread of the final electrical properties of the MOSFET. This, also together with the subsequent recession of the conductive gate region, may negatively impact the electrical performances of the MOSFET, especially in terms of capacity and uniformity of the threshold voltage Vₜₕ, reducing its reliability.

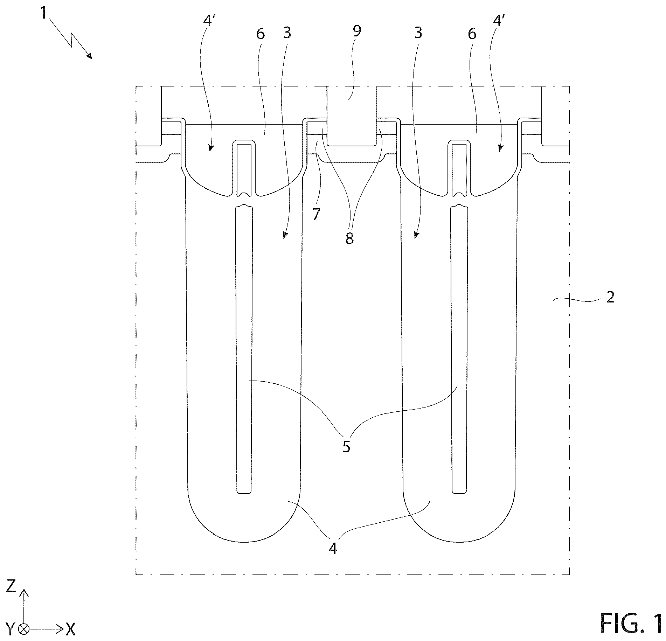

In detail, Figure 1 shows an example of one of these known MOSFET structures (here indicated with the reference 1), formed through a wet etching of the field plate oxide region.

In greater detail, the MOSFET 1 comprises a semiconductor body 2 with trenches 3 wherein respective insulating field plate regions 4 extend. A respective field plate 5 is buried in each insulating field plate region 4. Within a cavity 4' formed in the upper part of each insulating field plate region 4, a respective conductive gate region 6 is present; in other words, the conductive gate region 6 is vertically superimposed on both the respective insulating field plate region 4 and the respective field plate 5, in known solutions. In a manner still known per se, the MOSFET 1 also comprises further elements, such as body regions 7, source regions 8, a source metallization 9 in contact with the body regions 7 and the source regions 8, etc.

Other known solutions that allow improving the capacity Cᵣₛₛ, the current I_{gss} and UIS performances require using expensive processes such as chemical-mechanical polishing (CMP) with poly slurry, slow wet etching processes, highly uniform polysilicon deposition, and recession or etching of polysilicon through interferometric techniques. Furthermore, other known solutions require completely changing the approach to the formation of conduction channels, but this requires extremely complicated and accurate lithographic techniques, as well as approaches based on "double metal layers" or "double plugs layers". All these solutions mentioned here are extremely expensive and need new tools for manufacturing and/or developing new processes (e.g., with advanced integration of process steps), which therefore increase the development and production costs of MOSFETs.

Document US12015078B2 belongs to the field of semiconductor power device technology and to semiconductor power device manufacturing, in particular it relates to a manufacturing method of a semiconductor power device, which can ensure the quality of the gate, and do not affect the withstand voltage of the semiconductor power device.

Document CN104952718B relates to a method for manufacturing a split gate power device, which is stable and reliable, easy to control and high in yield.

Document US2024178289A1 relates to a method of forming a gate of a split-gate trench MOSFET, and to a split-gate trench MOSFET.

Document US9224854B2 relates to the field of semiconductor devices and, more particularly, to drain extended transistors in semiconductor devices.

### SUMMARY

The aim of the present invention is to provide an electronic device and a process for manufacturing the electronic device that overcome the drawbacks of the prior art and that in particular allow for increased reliability by virtue of a greater level of control over the depth of the conductive gate region and over the reduction of the spread of the capacity Cᵣₛₛ (or Miller capacity Cₘᵢₗₗₑᵣ) and of the threshold voltage Vₜₕ and by virtue of an improvement of the properties of the current I_{gss} and of the UIS performances.

According to the present invention, an electronic device and a process for manufacturing the electronic device are provided, as defined in the annexed claims which form an integral part of the present description.

### BRIEF DESCRIPTION OF THE DRAWINGS

For a better understanding of the present invention, a preferred embodiment is now described, purely by way of non-limiting example, with reference to the attached drawings, wherein:
- Figure 1 shows a cross-sectional view of a known electronic device;
- Figure 2 shows a cross-sectional view of an electronic device, according to one embodiment of the present invention;
- Figure 3 shows a schematic perspective view, along two different section lines, of the electronic device of Figure 2;
- Figure 4 shows a cross-sectional view of an electronic device, according to a different embodiment of the present invention;
- Figure 5 shows a schematic perspective view, along two different section lines, of the electronic device of Figure 4;
- Figure 6 shows a schematic perspective view with hidden parts, along two different section lines, of the electronic device of Figure 4; and
- Figures 7A-7M show schematic perspective views along two different section lines of manufacturing steps of the electronic device of Figure 4, according to one embodiment.

In particular, the Figures are shown with reference to a triaxial Cartesian system defined by an X axis, a Y axis and a Z axis, orthogonal to each other.

In the following description, elements common to the different embodiments have been indicated with the same reference numbers.

### DETAILED DESCRIPTION OF THE INVENTION

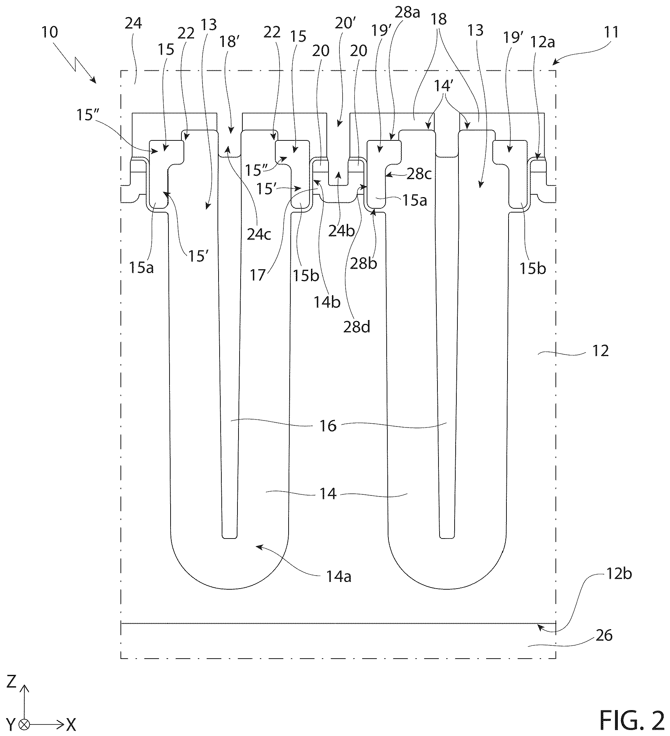

Figure 2 shows an electronic device 10, in detail a power MOSFET. In particular, the electronic device 10 is of the "split-gate" type, also called "shielded-gate" type. The electronic device 10 is hereinafter more simply also referred to as MOSFET 10

The MOSFET 10 is shown in Figure 2 in cross-sectional view, along an XZ section plane defined by the axes X and Z.

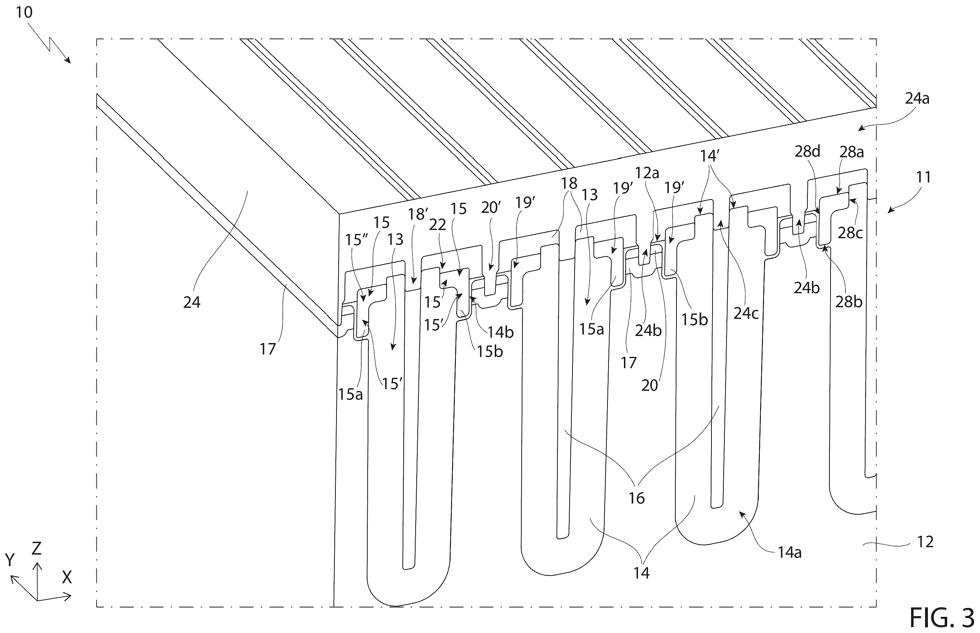

Furthermore, the MOSFET 10 of Figure 2 is also shown in Figure 3 in perspective view, in particular two cross-sectional views thereof are shown along two different section planes. In detail, the right section in Figure 3 is taken along the XZ section plane and corresponds to Figure 2, while the left section in Figure 3 is taken along a YZ section plane defined by the axes Y and Z and orthogonal to the XY plane.

In detail, the MOSFET 10 comprises a semiconductor body 12 having a first and a second side (or upper side and lower side) 12a, 12b, opposite to each other along the direction of the Z axis, and a first conductivity type (hereinafter, exemplarily N-type).

The MOSFET 10 also comprises a plurality of trenches (or "field plate" trenches) 13 in the semiconductor body 12, at the first side 12a.

As better shown in Figure 3, in a top view (i.e. parallel to an XY plane defined by the axes X and Y) the trenches 13 have a strip shape and are arranged at the side of each other to form an array of trenches 13.

In a top view the trenches 13 have respective main extension directions that are parallel to each other and, in the example shown, are parallel to the direction of the Y axis. Accordingly, the array alignment of the trenches 13 occurs along the X axis, in the example shown.

With reference again to Figure 2, the MOSFET 10 comprises, for each trench 13, a respective oxide region (or insulating field plate region) 14 extending at the lower and lateral walls of the trench 13.

The MOSFET 10 also comprises, for each trench 13, a respective field plate region 16, of electrically conductive material such as N-doped polysilicon. The field plate region 16 (hereinafter more simply also referred to as field plate 16) extends in the respective trench 13 and is buried within a main body 14a of the oxide region 14, in such a way as to be electrically insulated with respect to the semiconductor body 12.

The field plate 16 is used to reduce the electric field in the semiconductor body 12 near the trench 13 and to lower the parasitic capacitance.

The MOSFET 10 also comprises, for each trench 13, at least one respective conductive gate region (more simply also gate region) 15.

In particular, the MOSFET 10 comprises a first gate region 15a and a second gate region 15b for each trench 13. The first and the second gate regions 15a and 15b extend at the first side 12a and at respective sides (or lateral surfaces) of the oxide region 14 that are opposite to each other along the X axis.

For example, the first gate regions 15a and the second gate regions 15b are alternated to each other along the direction of the X axis. In other words, each pair of trenches 13 that are first neighboring to each other in the array has the first gate region 15a of one of the two trenches 13 (e.g., the right-hand trench 13, according to the direction of the X axis) and the second gate region 15b of the other of the two trenches 13 (e.g., the left-hand trench 13, according to the direction of the X axis) which are interposed between these two trenches 13 and which face each other, at a distance.

In detail, each of the first and the second gate regions 15a and 15b has a first gate portion 15' and a second gate portion 15", continuous with each other in such a way as to make the respective first or second gate region 15a and 15b monolithic.

In each of the first and the second gate regions 15a and 15b, the first gate portion 15' extends within the semiconductor body 12 so as to be lateral to the main body 14a of the oxide region 14 (i.e. to be in contact with a respective lateral wall of the main body 14a, the lateral wall being an outer wall of the main body 14a that faces the body region 17 cited in the following, i.e. that is vertically aligned to a sidewall of the respective trench 13), while the second gate portion 15' extends partly on the first gate portion 15' and partly on the main body 14a of the oxide region 14. In other words, the second gate portion 15' is vertically superimposed (i.e. superimposed along the direction of the Z axis) both on the first gate portion 15' and, partially, on the main body 14a of the oxide region 14.

The first and the second gate portions 15' and 15" are therefore joined to each other such that each of the first and the second gate regions 15a and 15b has, in cross-section, the shape of an inverted "L". In other words, in the cross-section of Figure 2 each gate region 15a, 15b has the first and the second gate portions 15' and 15" with respective main extensions orthogonal to each other (in detail, the first gate portion 15' with main extension parallel to the X axis and the second gate portion 15" with main extension parallel to the Z axis) and which have an upper end of the second gate portion 15" joined to a lateral end of the first gate portion 15', in such a way as to have the first and the second gate regions 15a and 15b that are transversal and therefore angled, in detail orthogonal, to each other. For example, the first and the second gate portions 15' and 15" may each have a substantially rectangular shape and are arranged to each other and joined in such a way as to form this inverted L shape, i.e. such that they have the mutual arrangement previously described and that the width along the X axis of the first gate portion 15' is lower than the width along the X axis of the second gate portion 15".

As may be seen in Figures 2 and 3, each gate region 15 extends laterally to the adjacent main body 14a at its second gate portion 15", while it protrudes within the main body 14a at its first gate portion 15', so as to have the latter that is at least partly vertically superimposed on the main body 14a.

In the embodiment of Figures 2 and 3, the gate regions 15 are at a distance from each other along the direction of the X axis, i.e., they are not directly electrically coupled to each other (in other words, insulating material which extends between the gate regions 15 is present along the direction of the X axis).

As better described hereinbelow, the gate regions 15a and 15b are electrically insulated both with respect to the respective field plate 16 and with respect to the semiconductor body 12 through the oxide region 14.

Each assembly of gate region 15a or 15b and respective oxide region 14 forms a respective gate structure 22 of the MOSFET 10. Since the field plates 16 are electrically insulated from the gate region 15, the gate structures 22 of the MOSFET 10 are known as "shielded-gate" or "split-gate" structures.

As evident from Figure 2, each of the first and the second gate regions 15a and 15b extends in a respective gate cavity (or trench) 19' which has a shape complementary to the shape of the respective gate region 15a and 15b and which, therefore, extends both in the semiconductor body 12, starting from the first side 12a and laterally to the main body 14a, and partly in the oxide region 14, starting from an upper surface 14' of the oxide region 14.

The MOSFET 10 also comprises, for each trench 13, a respective upper oxide region 18 extending over the trench 13 and on the gate regions 15. In particular, the upper oxide region 18 is vertically misaligned (i.e. it is not superimposed along the direction of the Z axis) with respect to the field plate 16; in other words, for each trench 13 the upper oxide region 18 has a respective through opening 18' that traverses it along the direction of the Z axis and that is vertically superimposed on the respective field plate 16.

The MOSFET 10 also comprises, for each trench 13, at least one body region 17 having a second conductivity type (here exemplarily of P-type).

In particular, each trench 13 is interposed along the direction of the X axis between two respective body regions 17, which therefore face respectively the sides of the trench 13 that are opposite to each other along the direction of the X axis. In greater detail, each body region 17 extends with continuity between the respective two trenches 13 that are first neighboring to each other in the array of trenches 13.

The body regions 17 are accommodated in the semiconductor body 12, laterally to the respective trench 13 and in such a way as to face the first side 12a of the semiconductor body 12, and have a main extension parallel to the direction of the Y axis.

The MOSFET 10 also comprises, for each trench 13, at least one source region 20 having the first conductivity type (here exemplarily of N-type).

In particular, each trench 13 is interposed along the direction of the X axis between two respective source regions 20, which therefore face respectively sides of the trench 13 that are opposite to each other along the direction of the X axis.

The source regions 20 are also accommodated in the semiconductor body 12, laterally to the respective trenches 13, and extend at the first side 12a of the semiconductor body 12 (in detail, their upper surface forms part of the first side 12a).

The source regions 20 extend on the body regions 17. In particular, the two source regions 20 which extend between two respective trenches 13 first neighboring to each other both extend on the same body region 17, at a distance from each other along the X axis.

In more detail, these two source regions 20 which extend between two respective trenches 13 first neighboring to each other are separated from each other through a through opening (or contact opening) 20' that is vertically superimposed on a portion of the respective body region 17 that, in a top view, is internal (therefore it is also referred to as the central portion of the body region 17). In other words, in a top view each body region 17 has a central portion, which is exposed by the respective source regions, and two respective extremal portions that are continuous with the central portion, extend laterally with respect to the central portion along the direction of the X axis and are covered by the respective source regions 20.

Accordingly, the source regions 20 and the body regions 17 also have a strip shape, with the main extension along the direction of the Y axis.

As evident, in use the MOSFET 10 forms a vertical conduction channel through each body region 17, along which the charge carriers move. In detail, this conduction channel is generated at the interface between the body region 17 and the gate region 15.

Each upper oxide region 18 covers, as well as the gate regions 15 of the respective trench 13, also the two respective source regions 20 that are adjacent to the respective trench 13.

Furthermore, each oxide region 14 physically separates and electrically insulates the two respective gate regions 15 from both the source regions 20 and the body regions 17 and from the semiconductor body 12.

In detail, each oxide region 14 comprises, as well as the main body 14a, also two respective portions (also referred to as insulation portions) 14b that are continuous with the main body 14a and that are each interposed between the respective gate region 15 and the adjacent source region 20, body region 17 and semiconductor body 12.

Each insulation portion 14b extends starting from the main body 14a and to the overlying upper oxide region 18 in such a way as to completely surround in cross-section, together with the upper oxide region 18 and the main body 14a, the respective gate region 15. In other words, each insulation portion 14b extends below and around, externally to the trench 13, the respective gate region 15.

In more detail, each gate region 15 has an upper surface 28a and a lower surface 28b, opposite to each other along the direction of the Z axis, and a first lateral surface (or internal lateral surface) 28c and a second lateral surface (or external lateral surface) 28d, opposite to each other along the direction of the X axis. In detail, the internal lateral surface 28c faces, through the main body 14a, the respective field plate 16 while the external lateral surface 28d faces, through the insulation portion 14b, both the semiconductor body 12 and the respective source region 20 and the respective body region 17.

In other words, the upper surface 28a is in contact with the upper oxide region 18, the internal lateral surface 28c is in contact with the respective lateral surface of the main body 14a, the lower surface 28b is in contact with part of the insulation portion 14b, and the external lateral surface 28d is in contact with the remaining part of the insulation portion 14b.

Accordingly, each oxide region 14 and the respective upper oxide region 18 completely surround, in cross-sectional view, the respective gate region 15, making it buried and thus electrically insulating it from the respective neighboring elements of the MOSFET 10.

In detail, as may be seen in Figure 2, the internal lateral surface 28c has a first portion at the first gate portion 15' and a second portion at the second gate portion 15", which are transversal, in detail orthogonal, to each other (in fact, the first portion extends in a manner substantially parallel to the Z axis while the second portion extends in a manner substantially parallel to the X axis). In other words, this first and second portions of the internal lateral surface 28c define, between each other, an angle (not shown) which in particular is equal to about 90°.

The MOSFET 10 also comprises a source metallization 24 which extends on the upper oxide regions 18, on the body regions 17 where exposed by the through openings 20', and on the field plates 16 where exposed by the through openings 18' .

In greater detail, the source metallization 24 comprises a main body 24a which extends on the upper oxide regions 18, respective first metallization portions 24b which extend on the respective body regions 17 where exposed by the through openings 20', and respective second metallization portions 24c which extend on the field plates 16 where exposed by the through openings 18'; in particular, the main body 24a extends with solution of continuity both with the first metallization portions 24b and with the second metallization portions 24c.

Accordingly, the source metallization 24 is in direct electrical contact with the body regions 17, the source regions 20 and the field plates 16. However, by virtue of the oxide regions 14 and the upper oxide regions 18, the source metallization 24 is not in electrical contact with the gate regions 15.

In use, the source metallization 24 operates as a source electrode and is biasable to a source voltage V_{S} (e.g., a ground voltage), with which the body regions 17, the source regions 20, and the field plates 16 may be biased.

Furthermore, the MOSFET 10 also comprises a drain metallization 26 which extends in contact with the semiconductor body 12 at the second side 12b.

In use, the drain metallization 26 operates as a drain electrode and is biasable to a drain voltage V_{D}, with which the semiconductor body 12 may be biased.

Furthermore, in a manner not shown, the MOSFET 10 also comprises a gate metallization which extends in contact with the gate regions 15.

In use, the gate metallization operates as a gate electrode and is biasable to a gate voltage V_{G}, with which the gate regions 15 may be biased.

In fact, Figures 2 and 3 show only an active area 11 of the MOSFET 10, which includes a plurality of strip-shaped cells, each defined by a respective trench 13. Externally to the active area 11, i.e. beyond an edge termination region (not shown as it is known), a lateral surface of the semiconductor body 12 is present, for example extending substantially orthogonally to the first side 12a. The lateral surface is formed following a dicing step of a Si wafer having a plurality of MOSFETs 10 formed therein. The dicing step has the function of separating a MOSFET 10 from another MOSFET 10 of the same wafer. The dicing occurs at a scribe line (not shown) of the Si wafer from which the MOSFET 10 is obtained. This scribe line surrounds at a distance, in the XY plane, the active area 11, and for example extends externally to a protection ring (not shown) that in a top view surrounds the active area 11. Externally to the active area 11 or in any case at the protection ring it is therefore possible to have the gate metallization that electrically contacts the gate regions 15, in a manner known per se and therefore not further described.

As evident, within the active area 11 each strip-shaped cell has planar symmetry with respect to a respective symmetry plane which is parallel to the YZ plane and passes through the field plate 16.

Returning to Figure 2, it is noted how the upper surface 28a is at a level (or height), along the direction of the Z axis, that is higher than the level of the source region 20 (e.g., of an upper surface thereof), while the lower surface 28b is at a level, along the direction of the Z axis, that is lower than the level of the body region 17, in particular it is level with the semiconductor body 12 (i.e. below an interface between semiconductor body 12 and body region 17). This ensures that in use the gate region 15 may form the conduction channel through the body region 17.

For example, the junction zone between the first and the second gate portions 15' and 15" is substantially at the same level, along the Z axis, as the upper surface of the source region 20.

For purely illustrative and non-limiting purposes, the gate regions 15 have a thickness, measured along the direction of the Z axis between the upper surface 28a and the lower surface 28b, comprised between about 0.9 µm and about 1.0 µm and for example equal to about 0.95 µm and, in detail, the first gate portion 15' has a thickness approximately uniform along the direction of the Z axis comprised between about 600 nm and about 730 nm and for example equal to about 650 nm while the second gate portion 15" has a thickness approximately uniform along the direction of the Z axis comprised between about 200 nm and about 300 nm and for example equal to about 250 nm; furthermore, the gate regions 15 have a maximum width, measured along the direction of the X axis between the lateral surfaces 28c and 28d at the second gate portion 15", comprised between about 270 nm and about 330 nm and for example equal to about 300 nm and have a minimum width, measured along the direction of the X axis between the lateral surfaces 28c and 28d at the first gate portion 15', comprised between about 100 nm and about 200 nm and for example equal to about 150 nm. Furthermore, the insulation portions 14b have a thickness that is substantially uniform and that coincides with the distance of the gate regions 15 with respect to the adjacent source regions 20, body regions 17 and semiconductor body 12; such thickness, for example measured along the direction of the Z axis below the lower surface 28b or measured along the direction of the X axis alongside the external lateral surface 28d, may be comprised between about 430 nm and about 510 nm and may for example be equal to about 470 nm.

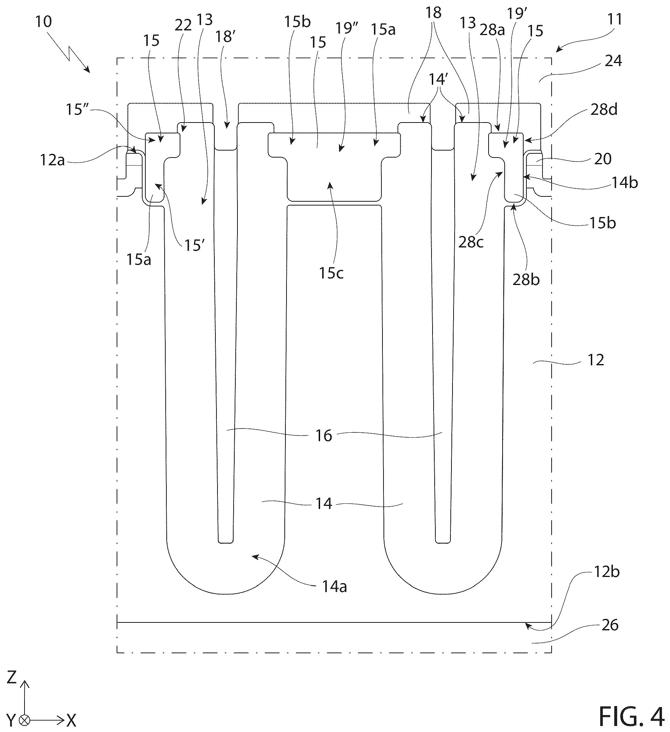

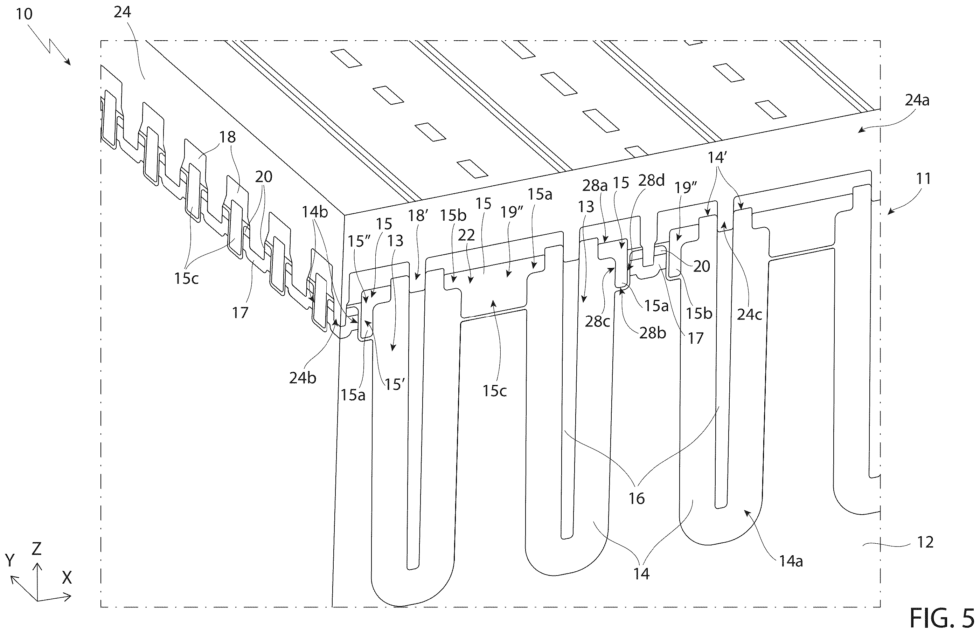

Figures 4 and 5 show the MOSFET 10 according to a different embodiment.

The views of Figures 4 and 5 are similar to those of Figures 2 and 3, respectively, to better highlight the comparison between the two embodiments of the MOSFET 10.

The MOSFET 10 of Figures 4 and 5 is similar to the MOSFET 10 of Figures 2 and 3, therefore it is not described in detail here except for highlighting its differences with respect to the MOSFET 10 of Figures 2 and 3.

In particular, in the embodiment of Figures 4 and 5, the MOSFET 10 also comprises gate connection regions (or more simply connection regions) 15c that physically and electrically connect to each other each pair of first and second gate regions 15a and 15b which, along the direction of the X axis, is interposed between two respective trenches 13.

The connection regions 15c are continuous with the respective first and second gate regions 15a and 15b, for example they are of the same material as these and are interposed therebetween along the direction of the X axis in such a way as to form a monolithic assembly therewith (i.e. a gate region 15 of the monolithic type).

In detail, each connection region 15c extends in the semiconductor body 12 starting from the first side 12a, until it reaches a depth in the semiconductor body 12 similar to that of the first and the second gate regions 15a and 15b. In more detail and as visible in Figure 4, each connection region 15c has an upper surface, aligned along the direction of the Z axis with the upper surfaces 28a of the adjacent first and second gate regions 15a and 15b, and a lower surface, opposite along the direction of the Z axis with respect to the upper surface and aligned along the direction of the Z axis with the lower surfaces 28b of the adjacent first and second gate regions 15a and 15b.

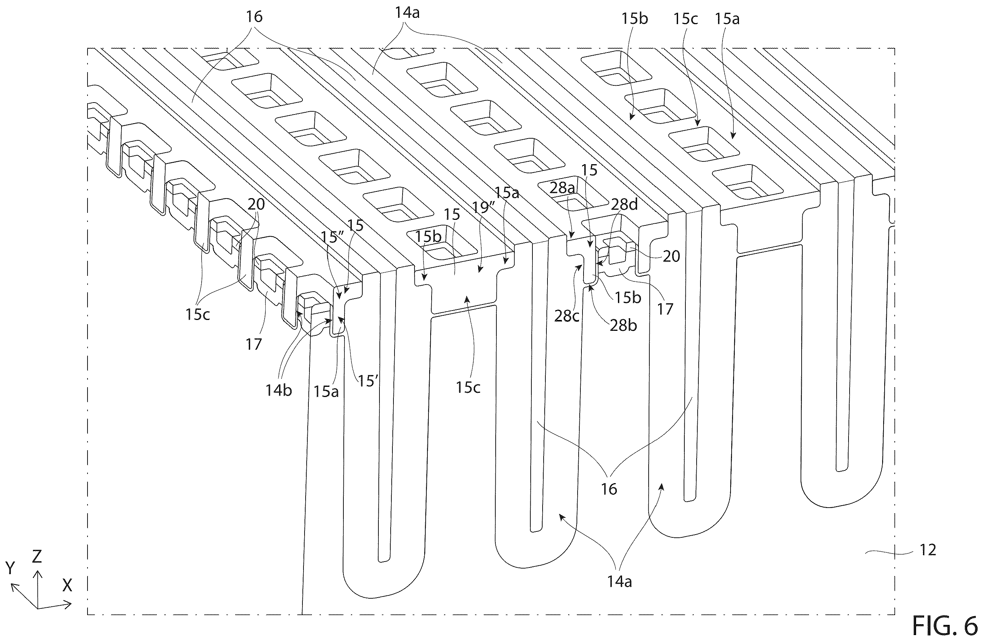

As is evident, in order to allow the electrical bias of the source regions 20 and the body regions 17, the connection regions 15c extend with interruptions, i.e. in a manner discontinuous with each other, along the direction of the Y axis. This is visible in Figure 5 and is even more clearly understandable with reference to Figure 6, which shows the device 10 of Figures 4 and 5 in a simplified manner (in detail, some parts are hidden for ease of view, such as the source metallization 24 and the upper oxide regions 18).

In fact, as shown in Figure 6, the connection regions 15c extend along the direction of the Y axis alternatively with respect to the body regions 17 and the source regions 20, which in this embodiment have a cell-shaped (or island-shaped) structure instead of a strip-shaped structure as previously.

In other words, here the body regions 17 and the source regions 20 have, in a top view, a closed polygonal shape (e.g., a square or rectangular shape) and a matrix arrangement. Each assembly of body region 17 and respective source regions 20 is therefore surrounded, in a top view, by the gate region 15: along the direction of the X axis it is adjacent to the first and the second gate regions 15a and 15b, while along the direction of the Y axis it is adjacent to two respective connection regions 15c.

In detail, the body regions 17 and the source regions 20 which extend between two respective trenches 13 are aligned with each other along the direction of the Y axis, to form an array of body regions 17 and source regions 20 that corresponds to a respective row of this matrix.

These arrays of body regions 17 and source regions 20 are parallel to each other. In the exemplary case shown in Figure 6, these arrays are offset to each other alternatively in the direction of the X axis, i.e. they are arranged such that in cross-section the connection regions 15c and the assemblies of body regions 17 and source regions 20 are aligned with each other alternatively along the direction of the X axis (e.g., in a same cross-section a connection region 15c is present between the first and the second trenches 13, an assembly of body region 17 and source region 20 is present between the second and the third trenches 13, a connection region 15c is present between the third and the fourth trenches 13, an assembly of body region 17 and source region 20 is present between the fourth and the fifth trenches 13, etc.). Nevertheless, other arrangements may be similarly considered, for example one in which the connection regions 15c are aligned with each other along the direction of the X axis, as are the assemblies of body regions 17 and source regions 20, and such arrays of connection regions 15c parallel to the X axis and arrays of assemblies of body regions 17 and source regions 20 parallel to the Y axis are alternated to each other along the direction of the Y axis.

For example, as shown in Figure 6, in a top view each body region 17 has a closed polygonal shape; furthermore, a respective source region 20 for each side of the external perimeter of such closed polygonal shape are present. In other words, these source regions 20 define a source region with an annular shape, which is superimposed on a radially external annular region of the body region 17. This radially external annular region surrounds a radially internal region of the body region 17, which instead is uncovered by the source regions 20 and is in contact with the source metallization 24.

As evident from Figure 4, each connection region 15c extends in a respective connection cavity (or trench) 19" which has a shape complementary to the shape of the respective connection region 15c and which, therefore, extends in the semiconductor body 12 starting from the first side 12a, between two trenches 13 adjacent to each other.

The connection regions 15c are electrically insulated with respect to the semiconductor body 12, for example through the respective insulation portions 14b. In detail, the insulation portions 14b, which insulate the first and the second gate regions 15a and 15b adjacent to the considered connection region 15c from the semiconductor body 12, are here joined to each other and also insulate this connection region 15c from the semiconductor body 12; in particular, they also extend here below and alongside the connection region 15c, so as to be interposed between this connection region 15c and the semiconductor body 12.

The presence of the connection regions 15c allows the on-resistance of the MOSFET 10 to be reduced, thus improving its electrical properties. In fact, in use the MOSFET 10 forms a vertical conduction channel, along which the charge carriers move, both at the interface between the body region 17 and the gate regions 15a and 15b and at the interface between the body region 17 and the connection region 15c. In particular, this second contribution is absent in the currently known solutions and, adding to the first contribution, generates a significant overall increase in the channel perimeter and channel area of the MOSFET 10. This significantly reduces the on-resistance of the MOSFET 10, in particular without having to resize the diffusion process or increase the lithographic resolution, thus saving in terms of costs and difficulties in the manufacturing steps. For example, by using the connection regions 15c an increase in the channel perimeter may be obtained equal to about 60% with respect to the case of Figure 2.

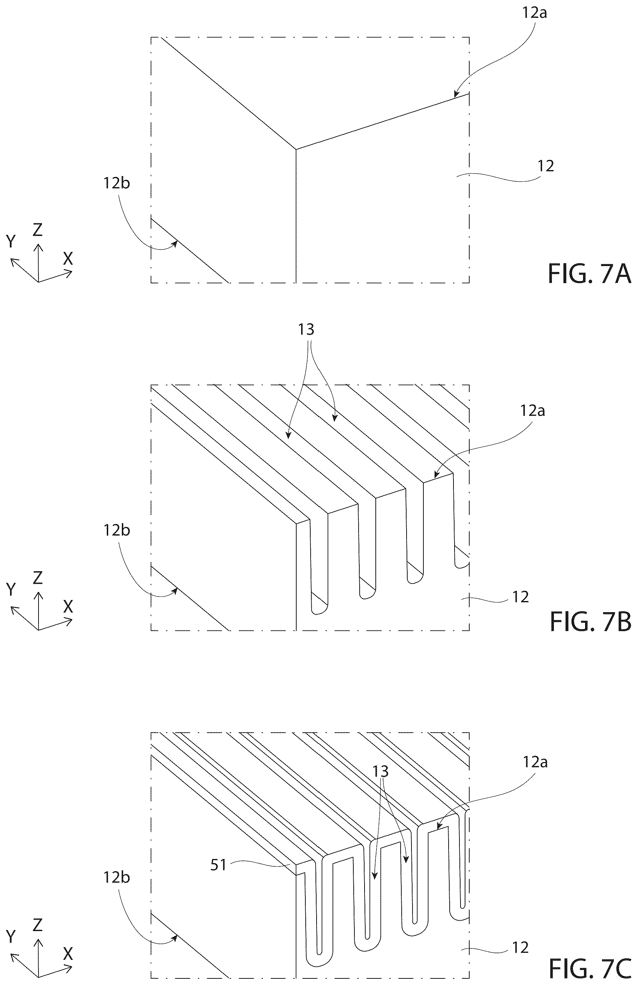

Figures 7A-7M illustrate a process for manufacturing the MOSFET 10, with exemplary reference to the embodiment of Figures 4 and 5.

Nevertheless, it is evident that the manufacturing steps described here may be simplified in an obvious manner to manufacture in a similar manner the MOSFET 10 of Figures 2 and 3.

In Figure 7A a semiconductor substrate is provided over which an optional epitaxial layer is grown. The substrate and the epitaxial layer form, together, the semiconductor body 12. The substrate and the epitaxial layer are for example of Silicon having an N-type doping.

Then, Figure 7B, the trenches 13 are formed by etching the semiconductor body 12 from the upper side 12a. The etching is performed by means of known techniques, such as RIE (Reactive Ion Etching) or DRIE (Deep Reactive Ion Etching). In the drawings, the trenches 13 have vertical lateral walls; depending on the process used to manufacture the trenches, they may also have tilted lateral walls, for example, of a truncated V-type shape in side view, or of a truncated inverted pyramid shape. The teaching of the present solution similarly applies also in the case of lateral walls of the trenches 13 not perfectly parallel to the Z axis.

Then, Figure 7C, the trenches 13 are partially filled with electrically insulating material, forming an insulating filling region 51 which is intended to form the main body 14a of the oxide regions 14. This step is performed, for example, by growing or depositing silicon oxide (SiO₂) in case the semiconductor body 12 is of Silicon; another insulating material may be grown or deposited based on the material of the semiconductor body 12. For example, the insulating filling region 51 may have a thickness, measured along the direction of the Z axis and starting from the upper side 12a, equal to about 600 nm.

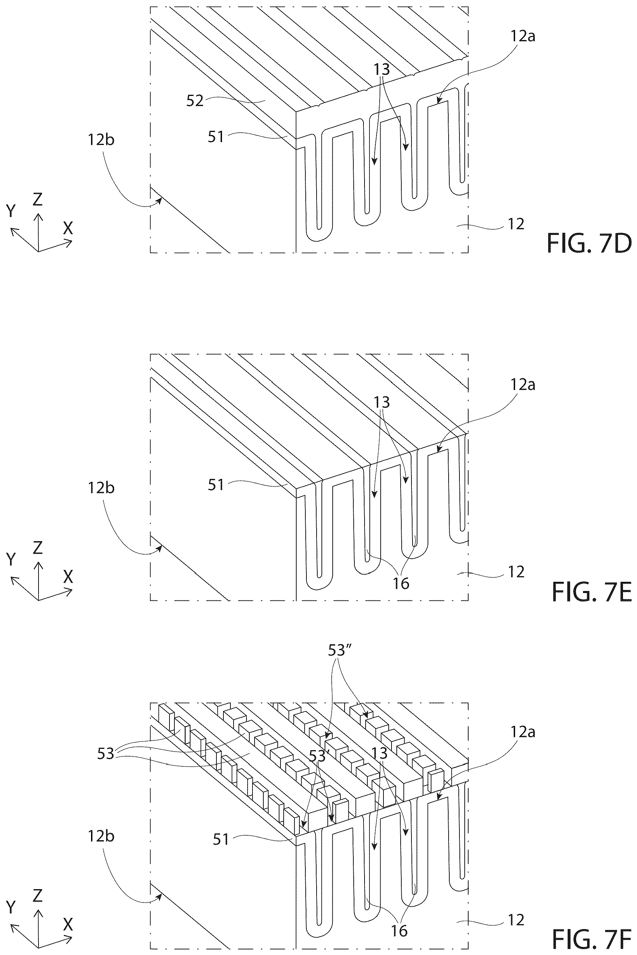

Then, Figure 7D, a step of filling the trenches 13 with conductive material is performed, forming a conductive region 52 in the trenches 13 and on the semiconductor body 12. The conductive material is for example N-doped polysilicon and completely fills the trenches 13. The conductive region 52 is intended to form the field plates 16.

Then, Figure 7E, a step for removing selective portions of the conductive region 52 over the upper side 12a of the semiconductor body 12 is performed, preserving the conductive region 52 within the trenches 13. The portions of the conductive region 52 that remain after this removal step form the field plates 16.

This step may be performed by means of a CMP (Chemical-Mechanical Polishing) technique. The conductive region 52 is then recessed in each trench 13 until the conductive region 52 is substantially level, along the direction of the Z axis, with the insulating filling region 51.

For example, following this removal through CMP the insulating filling region 51 may have a thickness, measured along the direction of the Z axis and starting from the upper side 12a, equal to about 400 nm.

Then, Figure 7F, a mask 53 is formed on the upper side 12a. The mask 53, for example of polymeric resin, is formed in particular on the insulating filling region 51 and on the field plates 16. The mask 53 exposes the zones of the insulating filling region 51 that are intended to house the gate regions 15a and 15b and the connection regions 15c and instead covers the field plates 16 and the remaining parts of the insulating filling region 51.

In more detail, the mask 53 has first openings 53' and, in the embodiment considered here, second openings 53" (which are instead absent if this manufacturing process is implemented to manufacture the MOSFET 10 of Figures 2 and 3). The first openings 53' extend at the point where the first and second gate regions 15a and 15b will be formed, while the second openings 53" extend at the point where the connection regions 15c will be formed.

In detail, the first openings 53' are vertically aligned (i.e. superimposed along the direction of the Z axis) with the lateral walls of the trenches 13, i.e. with the vertical interfaces between the main body 14a of the oxide regions 14 and the semiconductor material of the semiconductor body 12. The first openings 53' have a strip shape in a top view and have respective main extensions that are parallel to each other and with respect to the direction of the Y axis. In greater detail, each first opening 53' extends on part of the respective main body 14a, in particular at the respective considered lateral wall of the latter, and also on part of the adjacent semiconductor body 12. For example, each first opening 53' may extend for about 150 nm on the main body 14a and for about 150 nm on the semiconductor body 12, where both these distances are measured along the direction of the X axis and starting from the corresponding lateral wall of the trench 13.

Instead, the second openings 53" are vertically superimposed on the semiconductor body 12 present between the trenches 13 and each extend between two respective first openings 53', so as to make the latter facing and communicating with each other. In detail, a plurality of second openings 53" extend parallel to each other and so as to be interposed between the two respective first openings 53'. In more detail, the second openings 53" also have a strip shape in a top view and have a main extension parallel to the X axis. Accordingly, the second openings 53" which extend between two same first openings 53' are parallel to each other, aligned with each other along the direction of the Y axis to form a respective array and, for example, equispaced from each other; furthermore, different arrays of second openings 53" are parallel to each other and with respect to the Y axis, since they extend between respective different pairs of trenches 13. For example, each second opening 53" has a width, measured along the direction of the Y axis, that is equal to about 300 nm.

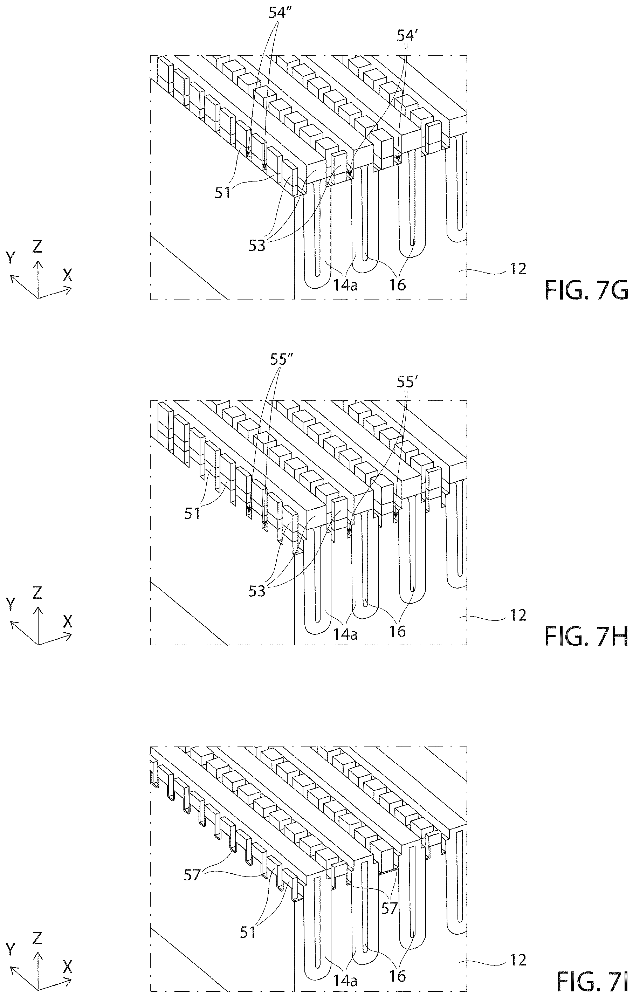

Then, Figure 7G, the insulating filling region 51 is partially etched at the upper side 12a, through the first and second openings 53' and 53" of the mask 53. This first etching allows upper gate trenches 54' and 54" to be formed at the zones of the insulating filling region 51 that are exposed by the mask 53. In particular, it allows first upper gate trenches 54' to be formed, which are vertically aligned with the first openings 53' and which are intended to house the first gate portions 15' of the gate regions 15a and 15b, and second upper gate trenches 54", which are vertically aligned with the second openings 53" and which are intended to house the upper portions of the connection regions 15c.

The first etching is selective towards the material of the insulating filling region 51 and preserves the material of the semiconductor body 12. In detail, the first etching is of the dry type, such as a "deep reactive ion etching".

In detail, the first etching is interrupted when the semiconductor body 12 is reached under the insulating filling region 51.

Then, Figure 7H, the semiconductor body 12 is partially etched starting from the upper side 12a, through the first and second openings 53' and 53" of the mask 53. This second etching allows lower gate trenches 55' and 55" to be formed at the zones of the semiconductor body 12 that are exposed by the upper gate trenches 54' and 54" (and therefore also by the mask 53). In fact, in this second etching the insulating filling region 51, etched as previously described, operates as a "hard mask" for this second etching, exposing through the upper gate trenches 54' and 54" the zones of the semiconductor body 12 to be removed.

In particular, this second etching allows to form first lower gate trenches 55', which are partly vertically aligned with the first upper gate trenches 54' and which are intended to house the second gate portions 15" of the gate regions 15a and 15b, and second lower gate trenches 55", which are vertically aligned with the second upper gate trenches 54" and which are intended to house the lower portions of connection regions 15c. Joining each first lower gate trench 55' and the overlying first upper gate trench 54' defines the respective gate cavity 19' which is intended to house the respective first or second gate region 15a and 15b, while joining each second lower gate trench 55" and the overlying second upper gate trench 54" defines the respective connection cavity 19" which is intended to house the respective connection region 15c.

The second etching is selective towards the material of the semiconductor body 12 and preserves the material of the insulating filling region 51. In detail, the second etching is of the dry type, in particular it is an anisotropic etching.

Accordingly, although the first upper gate trenches 54' also expose part of the insulating filling region 51 present in the trenches 13 (i.e. part of the main body 14a of the oxide regions 14), the material of the insulating filling region 51 is not removed by this etching. This allows the gate cavities 19' to be formed with the inverted L-shape previously described in detail.

In particular, the second etching is stopped when the lower gate trenches 55' and 55" have a depth, measured along the direction of the Z axis and starting from the upper side 12a, equal to about 650 nm.

Following this second etching, the mask 53 is removed, in a manner not shown and discussed in detail here.

Then, Figure 7I, an oxidation step is performed (e.g., exposing the wafer to an O₂ environment), to form an insulating layer 57 on the exposed surfaces of semiconductor material. The insulating layer 57 defines the insulation portions 14b that will electrically insulate both the gate regions 15a and 15b and the connection regions 15c.

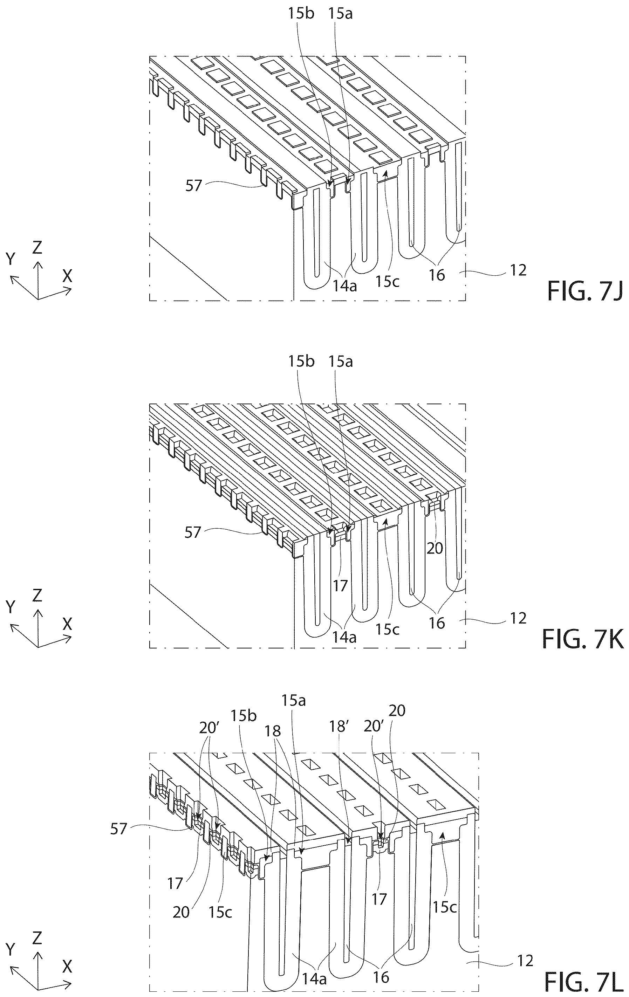

Then, Figure 7J, a formation step of the gate regions 15a and 15b and the connection regions 15c is performed. The gate regions 15a and 15b are formed by depositing conductive material (e.g., n-doped polysilicon) in the gate cavities 19', while the connection regions 15c are formed by depositing the same conductive material (e.g., n-doped polysilicon) in the connection cavities 19".

To this end, steps that are not described in detail here as they are known per se may also be performed, such as steps of CMP and recession of the conductive material to have the recessed regions of the conductive material level with the oxide material and steps of masking and etching the oxide to uncover the surface of the semiconductor material in order to then be able to perform the implants described below for the formation of the conduction channel.

Then, Figure 7K, the body regions 17 and the source regions 20 are formed by means of known implants of P-type and N-type doping species, respectively, in the semiconductor regions between the trenches 13.

Then, Figure 7L, the upper oxide regions 18 are formed on the gate regions 15a and 15b and on the connection regions 15c.

In detail, an upper oxide layer is first formed, for example through deposition, that uniformly covers the gate regions 15a and 15b, the connection regions 15c, the source regions 20 and the field plates 16. The upper oxide layer and the underlying source regions 20 are then etched between the trenches 13, to form the through openings 20' wherein the first metallization portions 24b will extend (e.g., this is done by means of a masking step and subsequent etching of the material of the upper oxide layer, followed by a further selective etching towards the semiconductor material of the source regions 20). Furthermore, the upper oxide layer is also etched over the field plates 16, to form the through openings 18' wherein the second metallization portions 24c will extend. Furthermore, per se known steps of implant and implant enhancement in the body regions 17 may also be performed.

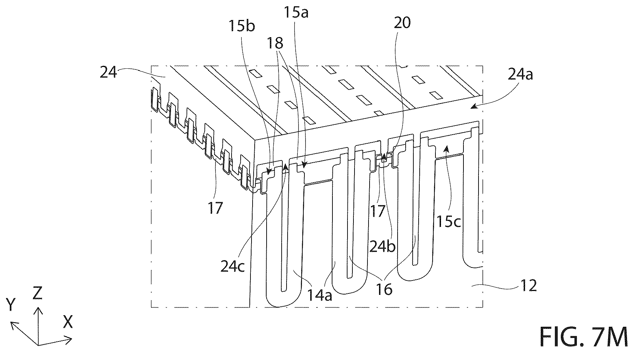

Then, Figure 7M, the source metallization 24 is formed, for example through deposition of conductive material. In detail, a layer of conductive material is uniformly deposited on the upper oxide regions 18 to form the main body 24a, in the through openings 20' to form the first metallization portions 24b, and in the through openings 18' to form the second metallization portions 24c. Accordingly, the first metallization portions 24b are in contact with the body regions 17 and the source regions 20, while the second metallization portions 24c are in contact with the field plates 16.

To complete the manufacture of the MOSFET 10, other steps may be performed that are not further described as they are not part of the present invention.

From an examination of the characteristics of the invention made according to the present invention, the advantages that it affords are evident.

In particular, the MOSFET 10 allows a greater level of control over the depth of the gate region 15 and over the reduction of the spread of the capacity Cᵣₛₛ (or Miller capacity Cₘᵢₗₗₑᵣ) and of the threshold voltage Vₜₕ and allows an improvement of the properties of the current I_{gss} and of the UIS performances. This is allowed by virtue of the previously described shape and arrangement of the gate regions 15, provided through dry etching instead of wet etching.

In fact, in the present solution no wet etching of the oxide region 14 is performed.

Furthermore, the oxide region 14 is used both to electrically insulate the gate region 15 from the respective source regions 20 and body regions 17, and as a "hard mask" during the etching of the semiconductor material. This second use simplifies the manufacturing process, allows a self-alignment of the elements previously described and reduces the number of masks required for implementing the MOSFET 10 compared to the known cases.

Furthermore, the self-alignment of the source regions 20 and the gate regions 15 may be obtained by implementing in the present manufacturing process the steps better described in the document EP4231361 A1, of the same Applicant. This is performed by using spacers of oxide material, formed on the source regions 20 laterally to the second portions 15" of the gate regions 15a and 15b. The self-alignment of the source regions 20 and the gate regions 15 improves the electrical performances and reduces the spread of the UIS properties, thus improving the reliability of the MOSFET 10. These steps are useful in the present case especially since the distance between the gate regions 15a and 15b, and therefore the width of the source regions 20, is reduced.

Furthermore, the second portion 15" of the gate regions 15a and 15b also serves to provide the self-aligned contact of the respective source region 20; in fact, it forms the wall having the insulation portion 14b resting thereon, which is interposed between the gate region 15a and 15b and the respective source region 20.

Furthermore, the manufacturing process described here reduces the number of masks required overall for the manufacturing of this type of MOSFET, compared to known solutions.

Furthermore, the use of the main body 14a of the oxide region 14 as electrical insulation between the field plates 16 and the gate regions 15a and 15b improves their electrical decoupling and therefore improves the current I_{gss} of the MOSFET 10.

Furthermore, since the width of the second gate portion 15", measured along the direction of the X axis, may also be lower than 40% of the similar width of the first openings 53', the MOSFET 10 may be further scaled compared to known solutions, with the same photolithographic performances.

Finally, it is clear that modifications and variations may be made to the invention described and illustrated here without thereby departing from the scope of the present invention, as defined in the attached claims.

For example, the different embodiments described may be combined with each other to provide additional solutions.

Furthermore, the present solution may be applied to any type of trench-gate vertical conduction device, such as, but not limited to, a VDMOS transistor, or a trench-based power MOSFET device.

## Claims

1. An electronic device (10), comprising:
a semiconductor body (12) having a first and a second side (12a, 12b) opposite to each other along a first axis (Z);
a plurality of trenches (13) extending within the semiconductor body (12) from the first side (12a) towards the second side (12b) and terminating within the semiconductor body (12), the trenches (13) being lateral to each other along a second axis (X) orthogonal to the first axis (Z);
a respective insulating field plate region (14) with a main body (14a) in each of said trenches (13), covering the lower and lateral walls of the respective trench (13);
a respective field plate region (16) in each of said trenches (13), each field plate region (16) being buried in the respective insulating field plate region (14) and being electrically insulated from the semiconductor body (12) by means of the respective insulating field plate region (14); and
a respective first conductive gate region (15a) for each of said trenches (13), each first conductive gate region (15a) extending within the semiconductor body (12) from the first side (12a) towards the second side (12b) and terminating within the semiconductor body (12), extending laterally to the main body (14a) of the respective insulating field plate region (14) along the second axis (X), being of conductive material and being electrically insulated from the semiconductor body (12) and the respective field plate region (16).

2. The electronic device according to claim 1, wherein each first conductive gate region (15a) comprises a first gate portion (15') and a second gate portion (15"), continuous with each other,
wherein, for each first conductive gate region (15a), the first gate portion (15') is in contact with a first lateral wall of the main body (14a) of the respective insulating field plate region (14), and the second gate portion (15") is partly superimposed along the first axis (Z) on the first gate portion (15') and is partly superimposed along the first axis (Z) on the main body (14a) of the respective insulating field plate region (14), the first lateral wall of the main body (14a) of the respective insulating field plate region (14) being an outer wall of said main body (14a).

3. The electronic device according to claim 2, wherein each first conductive gate region (15a) has an inverted L-shape.

4. The electronic device according to claim 2 or 3, wherein the semiconductor body (12) has a first conductivity type (N),
the electronic device (10) further comprising:
a plurality of body regions (17) extending at the first side (12a) between the trenches (13), the body regions (17) having a second conductivity type (P) opposite to the first conductivity type (N); and
a plurality of source regions (20) on the body regions (17),
wherein each first conductive gate region (15a) has the first gate portion (15') which is interposed along the second axis (X) between the main body (14a) of the respective insulating field plate region (14) and both the respective source region (20), the respective body region (17) and the underlying part of the semiconductor body (12), and
wherein each first conductive gate region (15a) is also electrically insulated with respect to the respective source region (20) and the respective body region (17).

5. The electronic device according to claim 4, wherein each insulating field plate region (14) further comprises at least one respective insulation portion (14b), of insulating material, which is continuous with the main body (14a) and extends between the respective first conductive gate region (15a) and both the respective source region (20), the respective body region (17) and the underlying part of the semiconductor body (12), in such a way as to electrically insulate the first conductive gate region (15a) from the respective source region (20), the respective body region (17) and the underlying part of the semiconductor body (12).

6. The electronic device according to any of claims 2-5, further comprising a respective second conductive gate region (15b) for each of said trenches (13), each second conductive gate region (15b) extending within the semiconductor body (12) from the first side (12a) towards the second side (12b) and terminating within the semiconductor body (12), extending laterally to the main body (14a) of the respective insulating field plate region (14) along the second axis (X), being of conductive material and being electrically insulated from the semiconductor body (12) and the respective field plate region (16),
wherein, for each trench (13), the first (15a) and the second (15b) conductive gate regions extend from parts of the main body (14a) of the respective insulating field plate region (14) that are opposite to each other along the second axis (X),
wherein each second conductive gate region (15b) comprises a respective first gate portion (15') and a respective second gate portion (15"), continuous with each other,
wherein, for each second conductive gate region (15b), the first gate portion (15') is in contact with a second lateral wall of the main body (14a) of the respective insulating field plate region (14), and the second gate portion (15") is partly superimposed along the first axis (Z) on the first gate portion (15') and is partly superimposed along the first axis (Z) on the main body (14a) of the respective insulating field plate region (14).

7. The electronic device according to claim 6, further comprising at least one gate connection region (15c) which extends within the semiconductor body (12) from the first side (12a) towards the second side (12b) and terminates within the semiconductor body (12), the gate connection region (15c) being electrically insulated from the semiconductor body (12),
wherein said gate connection region (15c) extends between a first conductive gate region (15a) and a second conductive gate region (15b) which are interposed along the second axis (X) between two respective trenches (13) adjacent to each other, the gate connection region (15c) physically and electrically connecting to each other said first (15a) and second (15b) conductive gate regions and being continuous with said first (15a) and second (15b) conductive gate regions.

8. The electronic device according to claims 4 and 7, comprising, for each pair of trenches (13) adjacent to each other, a respective plurality of said gate connection regions (15c) which are aligned with each other parallel to a third axis (Y) orthogonal to the first (Z) and the second (X) axes in such a way as to form a respective array and which are spaced from each other parallel to the third axis (Y),
wherein, in each array of gate connection regions (15c), the gate connection regions (15c) and said body regions (17) extend alternatively from each other parallel to the third axis (Y).

9. The electronic device according to claim 8, wherein the gate connection regions (15c) of the different arrays are offset to each other alternatively along the second axis (X) .

10. The electronic device according to any of the preceding claims, being of the vertical conduction type.

11. A process for manufacturing an electronic device (10), comprising the steps of:
forming a plurality of trenches (13) within a semiconductor body (12), the semiconductor body (12) having a first and a second side (12a, 12b) opposite to each other along a first axis (Z), the trenches (13) extending from the first side (12a) towards the second side (12b) and terminating within the semiconductor body (12), the trenches (13) being lateral to each other along a second axis (X) orthogonal to the first axis (Z);
forming a respective insulating field plate region (14) with a main body (14a) in each of said trenches (13), covering the lower and lateral walls of the respective trench (13);
forming a respective field plate region (16) in each of said trenches (13), each field plate region (16) being buried in the respective insulating field plate region (14) and being electrically insulated from the semiconductor body (12) by means of the respective insulating field plate region (14); and
forming a respective first conductive gate region (15a) for each of said trenches (13), each first conductive gate region (15a) extending within the semiconductor body (12) from the first side (12a) towards the second side (12b) and terminating within the semiconductor body (12), extending laterally to the main body (14a) of the respective insulating field plate region (14) along the second axis (X), being of conductive material and being electrically insulated from the semiconductor body (12) and from the respective field plate region (16).

12. The manufacturing process according to claim 11, wherein the step of forming the respective first conductive gate region (15a) for each of said trenches (13) comprises the steps of:
partially removing, at the first side (12a), a respective insulating filling region (51), which extends on the first side (12a) of the semiconductor body (12) and in each trench (13), and the semiconductor body (12), to form at least one respective gate cavity (19') for each trench (13), each gate cavity (19') extending through the insulating filling region (51) and within the semiconductor body (12) starting from the first side (12a);
forming an insulating layer (57) in the gate cavities (19'), the portions of the insulating layer (57) present in the gate cavities (19') defining insulation portions (14b) which extend in the gate cavities (19'); and
inserting conductive material in the gate cavities (19'), said conductive material in the gate cavities (19') defining the first conductive gate regions (15a) such that the insulation portions (14b) are interposed between the first conductive gate regions (15a) and the semiconductor body (12) in the gate cavities (19'),
wherein each gate cavity (19') comprises a first lower gate trench (55') and a first upper gate trench (54'), continuous with each other,
wherein, for each gate cavity (19'), the first lower gate trench (55') is in contact with a first lateral wall of the main body (14a) of the respective insulating field plate region (14), and the first upper gate trench (54') is partly superimposed along the first axis (Z) on the first lower gate trench (55') and is partly superimposed along the first axis (Z) on the main body (14a) of the respective insulating field plate region (14), the first lateral wall of the main body (14a) of the respective insulating field plate region (14) being an outer wall of said main body (14a).

13. The manufacturing process according to claim 12, wherein the step of partially removing the insulating filling region (51) and the semiconductor body (12) to form the gate cavities (19') comprises the steps of:
forming a mask (53) on the insulating filling region (51) and on the main body (14a) of the insulating field plate regions (14), the mask (53) having first openings (53') superimposed along the first axis (Z) on the first upper gate trenches (54');
selectively removing portions of the insulating filling region (51) through the first openings (53') until locally exposing the first side (12a) of the semiconductor body (12), to form said first upper gate trenches (54');
selectively removing portions of the semiconductor body (12) starting from the first side (12a) and through the first upper gate trenches (54'), to form said first lower gate trenches (55').

14. The manufacturing process according to claim 13, wherein the step of selectively removing the portions of the insulating filling region (51) to form the first upper gate trenches (54') comprises performing a first dry-type etching, and
wherein the step of selectively removing the portions of the semiconductor body (12) to form the first lower gate trenches (55') comprises performing a second anisotropic dry-type etching.

15. The manufacturing process according to any of claims 11-14, further comprising the step of forming at least one gate connection region (15c) which extends within the semiconductor body (12) from the first side (12a) towards the second side (12b) and terminates within the semiconductor body (12), the gate connection region (15c) being electrically insulated from the semiconductor body (12),
wherein said gate connection region (15c) extends between a first conductive gate region (15a) and a second conductive gate region (15b) that are interposed along the second axis (X) between two respective trenches (13) adjacent to each other, the gate connection region (15c) physically and electrically connecting to each other said first (15a) and second (15b) conductive gate regions and being continuous with said first (15a) and second (15b) conductive gate regions.

16. The manufacturing process according to claims 13 and 15, wherein the step of forming at least one gate connection region (15c) comprises the steps of:
partially removing, at the first side (12a), the insulating filling region (51) and the semiconductor body (12) also to form at least one respective connection cavity (19") between two trenches (13) adjacent to each other, the connection cavity (19") extending through the insulating filling region (51) and within the semiconductor body (12) starting from the first side (12a);
forming the insulating layer (57) also in the connection cavities (19"), the portions of the insulating layer (57) present in the connection cavities (19") defining respective insulation portions (14b) which extend in the connection cavities (19"); and
inserting the conductive material also in the connection cavities (19"), said conductive material in the connection cavities (19") defining the gate connection regions (15c) such that the respective insulation portions (14b) are interposed between the gate connection regions (15c) and the semiconductor body (12) in the connection cavities (19").
